# EUROPEAN PATENT APPLICATION

(11) **EP 4 811 019 A1**
(43) Date of publication of application: **23.09.2026**
(21) Application number: 24891294.1
(22) Date of filing: 06.11.2024
(51) Int. Cl.: G02B 27/02, G02B 6/00

(54) **LIGHT GUIDE MEMBER**

(30) Priority: 13.11.2023 JP 2023192708
(71) Applicant: SHIN-ETSU CHEMICAL CO., LTD., Tokyo 100-0005 (JP)
(72) Inventor: KATO, Koji, Annaka-shi, Gunma 379-0195 (JP)
(74) Representative: Vossius & Partner Patentanwälte Rechtsanwälte mbB
(86) International application number: PCT/JP2024/039401
(87) International publication number: WO 2025/105255

(57) **Abstract**

The present invention provides a light guide member for use in a waveguide structure of an image display device, which waveguide structure guides image light entering from a display to emit the image light toward an eye of a user, and is characterized in that the light guide member is formed of a single crystal of lithium niobate. According to the present invention, it is possible to provide a light guide member having a high refractive index and a high internal transmittance.

## Description

### Technical Field

The present invention relates to a light guide member for use in a waveguide structure of image display devices, such as a head-mounted display and smart glasses.

### Background Art

In recent years, head-mounted displays and smart glasses have been in practical use as a device that enlarges a two-dimensional image by an optical system to allow user's eyes to observe the enlarged virtual image.

The head-mounted displays and smart glasses are classified into a see-through transmission type and a non-transmission type. Many smart glasses belong to a transmission type and are used to project a new augmented reality (AR) or the like on a real world, and thus, a compact, portable type is desired. Many head-mounted displays belong to a non-transmission type and are used to project a virtual reality (VR) or the like, and thus, provision of a high field of view (FOV) which gives a sense of immersion is desired.

Such a head-mounted display is described in PTL 1, for example. The head-mounted display described in PTL 1 includes a display device that displays an image, a light guide member which the image displayed on a display element enters, and a propagation means that allows the entering image to be totally reflected inside the light guide member to propagate the image toward user's pupils. Then, the light guide member is formed of a glass material having a refractive index of 2.0 to 2.1 so as to give a prescribed viewing angle.

### Citation List

### Patent Literature

PTL 1: JP 2023-14127 A

### Summary of Invention

### Technical Problem

According to the light guide member described in PTL 1, the glass has a high refractive index of 2.0 or more, but has an internal transmittance at a wavelength of 400 nm in a plate thickness of 10 mm of about 0.61 to 0.75. In recent years, a higher internal transmittance has been desired for efficiently projecting a clear image with a high color reproducibility. In addition, a wider FOV is also demanded in the application to VR or AR, and thus, a material having a higher refractive index is needed.

The present invention has been made in view of the above circumstance and has an object to provide a light guide member that has a high refractive index and a high internal transmittance.

### Solution to Problem

As a result of intensive and extensive studies, the present inventors have found that the above problem can be solved by forming a light guide member with a single crystal of lithium niobate, thus completing the present invention described below. Specifically, the present invention provides the following [1] to [7].
[1] A light guide member for use in a waveguide structure of an image display device, which waveguide structure guides image light entering from a display to emit the image light toward an eye of a user, the light guide member being formed of a single crystal of lithium niobate.
[2] The light guide member according to the above [1], wherein the light guide member has a first surface and a second surface facing each other, the first surface and the second surface each having a plane orientation in an X axis direction or a Z axis direction of crystallographic axes.
[3] The light guide member according to the above [2], wherein a difference between a maximum value and a minimum value of a distance from the first surface to the second surface is 2 µm or less.
[4] The light guide member according to the above [2] or [3], wherein a parallelism between the first surface and the second surface is 2.5 arcsec or less.
[5] The light guide member according to any one of the above [2] to [4], wherein the first surface and the second surface of the light guide member each have a surface roughness Sq of 1 nm or less.
[6] The light guide member according to any one of the above [1] to [5], wherein the light guide member has an internal transmittance of light at a wavelength of 400 to 800 nm of 90% or more as calculated based on a thickness of 10 mm.
[7] The light guide member according to any one of the above [1] to [6], wherein the light guide member has a plate thickness of 0.3 mm or more and 1.0 mm or less.

### Advantageous Effects of Invention

According to the present invention, it is possible to provide a light guide member that has a high refractive index and a high internal transmittance.

In addition, use of the light guide member of the present invention makes it possible to realize an image display device, such as head-mounted display or smart glasses, that can efficiently project a clear image and can give a wider FOV.

### Brief Description of Drawings

[Fig. 1] Fig. 1 is a diagram showing a crystal structure of lithium niobate.
[Fig. 2] Fig. 2 is a graph showing a wavelength dependency of the refractive index of lithium niobate.
[Fig. 3] Fig. 3 is a diagram showing an example of a waveguide structure of an image display device.

### Description of Embodiments

The light guide member of the present invention is used for a waveguide structure of an image display device, which waveguide structure guides image light entering from a display toward an eye of a user. The light guide member of the present invention is formed of a single crystal of lithium niobate.

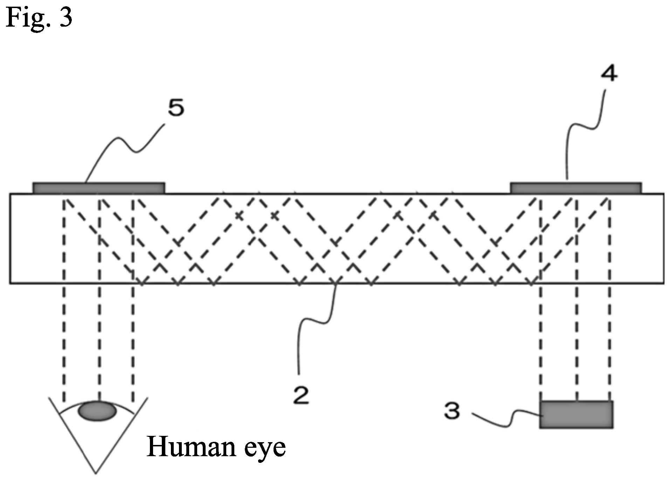

Examples of the image display device in which the light guide member of the present invention is used include a head-mounted display and smart glasses. Fig. 3 shows an example of a waveguide structure of an image display device. Image light (RGB light) emitted from a display 3 is diffracted by an input grating (diffraction grating) 4 and travels inside a light guide member 2 while repeating total reflection in the in-plane direction. The guided light is diffracted again by an output grating 5, goes out of the light guide member 2, and is guided to an eye of a user.

The light guide member of the present invention is formed of a single crystal of lithium niobate. The refractive index of lithium niobate to a wavelength of visible light is 2.2 or more, and thus, a high FOV can be obtained by using a single crystal of lithium niobate in a light guide member of an image display device, such as a head-mounted display or smart glasses.

The light guide member has a first surface and a second surface facing each other, and the plane orientation of the first surface and the plane orientation of the second surface are each preferably the X axis of the crystallographic axes. This can reduce the influence of the intrinsic pyroelectricity of lithium niobate. Note that pyroelectricity is a property of a crystal in which the polarization therein changes by temperature change to allow the crystal to carry static electricity. When pyroelectricity occurs in a production process, electricity is discharged in the production process, sometimes leading to an undesirable problem. The shifts in angle of the plane orientation of the first surface and the plane orientation of the second surface from the X axis of the crystallographic axes are each preferably -0.2 or more and +0.2 or less.

In addition, when the plane orientation of the first surface and the plane orientation of the second surface are each the X axis of the crystallographic axes, the first surface and the second surface have an equal property in a machining process, facilitating the machining process.

Besides the X axis of the crystallographic axes, the plane orientation of the first surface and the plane orientation of the second surface are each preferably the Z axis of the crystallographic axes. Regarding lithium niobate, a large bulk single crystal can be grown by the Czochralski method, that is, by pulling a raw material melt molten in a crucible upward under a temperature gradient. When the pulling axis is the Z axis, the crystallinity of the grown crystal is improved. From the viewpoint of production efficiency, the plane orientation of the first surface and the plane orientation of the second surface are each preferably the Z axis which is the pulling axis . The shifts in angle of the plane orientation of the first surface and the plane orientation of the second surface from the Z axis of the crystallographic axes are each preferably -0.2 or more and +0.2 or less.

In the light guide member of the present invention, the difference between the maximum value and the minimum value of the distance from the first surface to the second surface is preferably 2 µm or less. When the difference between the maximum value and the minimum value of the distance from the first surface to the second surface is 2 µm or less, the blurriness or bleeding of RGB light can be reduced. From this point of view, the difference between the maximum value and the minimum value of the distance from the first surface to the second surface is further preferably 1 µm or less. Such a difference between the maximum value and the minimum value of the distance from the first surface to the second surface is referred to as total thickness variation (TTV). For example, by polishing the single crystal of lithium niobate so that the difference between the maximum value and the minimum value of the distance from the first surface to the second surface becomes 2 µm or less, the difference between the maximum value and the minimum value of the distance from the first surface to the second surface can be 2 µm or less.

In order to securely guide light having each wavelength of RGB by the grating, in the light guide member of the present invention, a higher parallelism between the first surface and the second surface is more preferable, and the parallelism is preferably 2.5 arcsec or less. When the parallelism between the first surface and the second surface is 2.5 arcsec or less, the RGB light can be guided into the grating more securely. From this point of view, the parallelism between the first surface and the second surface is more preferably 1.5 arcsec or less. Note that the parallelism is evaluated by an index of wedge angle (Wedge) in JISB0615-2:2017. In addition, for example, by polishing the single crystal of lithium niobate so that the parallelism between the first surface and the second surface becomes 2.5 arcsec or less, the parallelism between the first surface and the second surface in the light guide member can be 2.5 arcsec or less.

From the viewpoint of guiding light having each wavelength of RGB so that the light propagates inside a light guide part and is totally reflected on the interface with the air (the surface), a smaller surface roughness Sq of the first surface and a smaller surface roughness Sq of the second surface of the light guide member of the present invention is better, and the surface roughnesses Sq are each preferably 1 nm or less and more preferably 0.5 nm or less. Note that the surface roughness Sq of the first surface and the surface roughness Sq of the second surface are each the surface roughness defined in ISO25178. For example, by polishing the single crystal of lithium niobate so that the surface roughness Sq of the first surface and the surface roughness Sq of the second surface each becomes 1 nm or less, the surface roughness Sq of the first surface and the surface roughness Sq of the second surface of the light guide member of the present invention can each be 1 nm or less.

In order to exactly guide RGB light, a higher transmittance of each wavelength is more preferable. Then, the internal transmittance of light at a wavelength of 400 to 800 nm of the light guide member of the present invention is preferably 90% or more as calculated based on a thickness of 10 mm. When a single crystal of lithium niobate that has an internal transmittance at a wavelength of 400 to 800 nm in a plate thickness of 10 mm of 0.9 or more is used, the internal transmittance of light at a wavelength of 400 to 800 nm of the light guide member of the present invention can be 90% or more as calculated based on a thickness of 10 mm. A higher internal transmittance of light at a wavelength of 400 to 800 nm of the light guide member of the present invention is more desirable, and the internal transmittance is further preferably 95% or more as calculated based on a thickness of 10 mm. Note that the upper limit of the range of the internal transmittance of light at a wavelength of 400 to 800 nm of the light guide member of the present invention is not particularly limited, but is 100% or more as calculated based on a thickness of 10 mm.

The plate thickness of the light guide member of the present invention is preferably 0.3 mm or more and 1.0 mm or less. When the plate thickness is 0.3 mm or more, the light guide member is further resistant to fracture. In addition, when the plate thickness is 1.0 mm or less, the light guide member can be lighter so that the tired feeling in wearing the image display device can be reduced.

The higher the refractive index of the light guide member, the shorter the optical path length in air of light traveling in the light guide member, and the higher the refractive index of the light guide member. the larger the apparent viewing angle with respect to the width of an image display element. Thus, a higher refractive index of the light guide member of the present invention is better, and the refractive index is preferably 2.2 or more. When a single crystal of lithium niobate is used for the light guide member, the refractive index of the light guide member of the present invention can be 2.2 or more.

Of course, there are individual differences, but it is considered that a viewing angle of about 45 degrees or more can give a picture with a sense of reality.

### Examples

Examples will be described below, but the present invention is not to be limited to the examples.

### <Example 1>

A lithium niobate (LN) single crystal ingot with a 6-inch diameter, which was pulled up by a CZ method with a crystal growth direction being the X axis direction, was sliced in an X cutting surface, followed by chamfering and lapping.

Next, polishing was performed with a double side polishing machine for mirror finishing of both the surfaces. The processing conditions were a pressure of 100 g/cm² and a rotation speed of the lower surface plate of 20 rpm, and colloidal silica was used as an abrasive. Through the polishing, a 6-inch φ LN substrate with a thickness of 0.5 mm with a major surface being the X surface was produced.

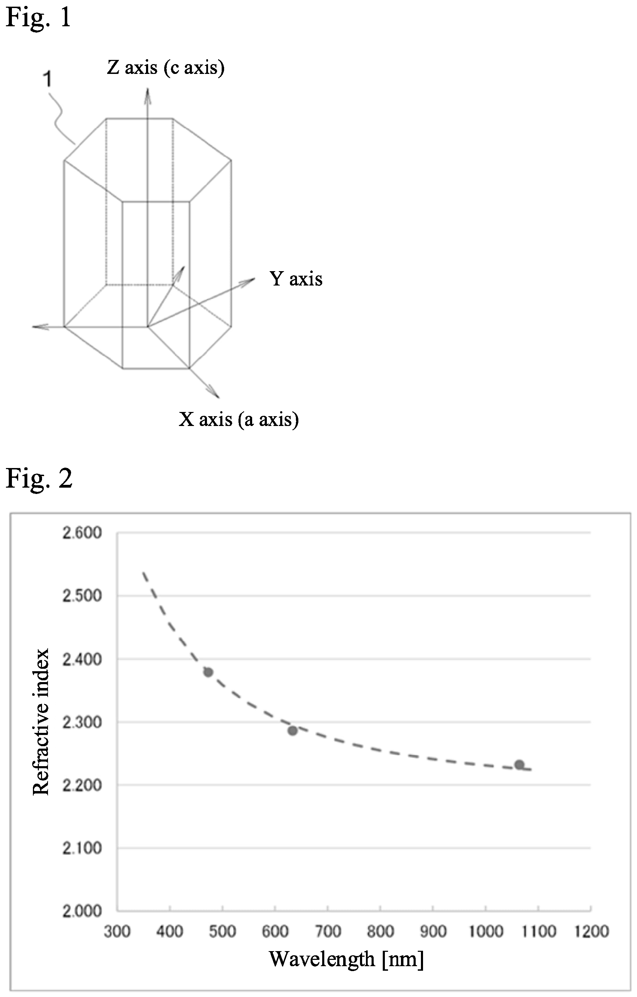

The refractive index of the LN substrate was measured using Prism Coupler, model 2010/M, manufactured by Metricon. The wavelengths used were 473, 633, and 1064 nm. Fig. 2 shows the measurement results. In a visible light region of 400 to 800 nm, high refractive indices of 2.2 or more were measured.

Other properties of the light guide member were as follows.
Plane orientations of first surface and second surface: X axis of crystallographic axes
Internal transmittance: 91.1%
TTV: 1.3 um
Parallelism: 1.8 arcsec
Surface roughness Sq: first surface 0.5 nm, second surface 0.5 nm
Thickness: 0.6 mm

The crystal orientation was measured with a cut surface inspection machine using X rays manufactured by Rigaku Corporation. The internal transmittance was measured with UV-3100 model manufactured by Shimadzu Corporation using samples of 3 mm and 10 mm produced by a method described in JOGIS 17:2019. The TTV and the parallelism were measured with UltraSort II manufactured by Tropel. The parallelism was evaluated by an index of wedge angle (Wedge) in JISB0615-2:2017. The roughness was measured in a region of 400×400 um using a white light interferometer, Zegage Plus, manufactured by Zygo to calculate the Sq value. The Sq refers to the Sq value defined in JISO25178. The thickness was measured with a micrometer.

Next, a multilayered antireflection film was formed on both the surfaces of the LN substrate. Then, the LN substrate was machined into 60 × 50 mm to produce a light guide member.

Smart glasses were produced using the light guide member, and an image projected on the smart glasses was visually observed. Then, it was found that the viewing angle was as sufficiently wide as 50 degrees and that an image with a clear color without blurriness or bleeding was displayed.

### <Example 2>

An LN single crystal ingot with a 6-inch diameter, which was pulled up by a CZ method with a crystal growth direction being the X axis direction, was sliced in an X cutting surface, followed by chamfering and lapping.

Next, polishing was performed with a double side polishing machine for mirror finishing of both the surfaces. The processing conditions were a pressure of 150 g/cm² and a rotation speed of the lower surface plate of 15 rpm, and colloidal silica was used as an abrasive. Through the polishing, a 6-inch φ LN substrate with a thickness of 0.5 mm with a major surface being the X surface was produced.

Other properties of the light guide member were as shown in Table 1.

Next, a multilayered antireflection film was formed on both the surfaces of the LN substrate. Then, the LN substrate was machined into 60 × 50 mm to produce a light guide member.

Smart glasses were produced using the light guide member, and an image projected on the smart glasses was visually observed. Then, it was found that the viewing angle was as sufficiently wide as 49 degrees and that an image with a clear color without blurriness or bleeding was displayed.

### <Example 3>

An LN single crystal ingot with a 6-inch diameter, which was pulled up by a CZ method with a crystal growth direction being the X axis direction, was sliced in an X cutting surface, followed by chamfering and lapping.

Next, polishing was performed with a double side polishing machine for mirror finishing of both the surfaces. The processing conditions were a pressure of 100 g/cm² and a rotation speed of the lower surface plate of 20 rpm, and colloidal silica was used as an abrasive. Through the polishing, a 6-inch φ LN substrate with a thickness of 0.3 mm with a major surface being the X surface was produced.

Other properties of the light guide member were as shown in Table 1.

Next, a multilayered antireflection film was formed on both the surfaces of the LN substrate. Then, the LN substrate was machined into 60 × 50 mm to produce a light guide member.

Smart glasses were produced using the light guide member, and an image projected on the smart glasses was visually observed. Then, it was found that the viewing angle was as sufficiently wide as 52 degrees and that an image with a clear color without blurriness or bleeding was displayed.

### <Example 4>

An LN single crystal ingot with a 6-inch diameter, which was pulled up by a CZ method with a crystal growth direction being the X axis direction, was sliced in an X cutting surface, followed by chamfering and lapping.

Next, polishing was performed with a double side polishing machine for mirror finishing of both the surfaces. The processing conditions were a pressure of 100 g/cm² and a rotation speed of the lower surface plate of 20 rpm, and colloidal silica was used as an abrasive. Through the polishing, a 6-inch φ LN substrate with a thickness of 1.0 mm with a major surface being the X surface was produced.

Other properties of the light guide member were as shown in Table 1.

Next, a multilayered antireflection film was formed on both the surfaces of the LN substrate. Then, the LN substrate was machined into 60 × 50 mm to produce a light guide member.

Smart glasses were produced using the light guide member, and an image projected on the smart glasses was visually observed. Then, it was found that the viewing angle was as sufficiently wide as 51 degrees and that an image with a clear color without blurriness or bleeding was displayed.

### <Example 5>

An LN single crystal ingot with a 6-inch diameter, which was pulled up by a CZ method with a crystal growth direction being the Z axis direction, was sliced in an Z cutting surface, followed by chamfering and lapping.

Next, polishing was performed with a double side polishing machine for mirror finishing of both the surfaces. The processing conditions were a pressure of 100 g/cm² and a rotation speed of the lower surface plate of 20 rpm, and colloidal silica was used as an abrasive. Through the polishing, a 6-inch φ LN substrate with a thickness of 1.0 mm with a major surface being the Z surface was produced.

Other properties of the light guide member were as shown in Table 1.

Next, a multilayered antireflection film was formed on both the surfaces of the LN substrate. Then, the LN substrate was machined into 60 × 50 mm to produce a light guide member.

Smart glasses were produced using the light guide member, and an image projected on the smart glasses was visually observed. Then, it was found that the viewing angle was as sufficiently wide as 50 degrees and that an image with a clear color without blurriness or bleeding was displayed.

### <Comparative Example 1>

An LN single crystal ingot with a 6-inch diameter, which was pulled up by a CZ method with a crystal growth direction being the Y axis direction, was sliced in an Y cutting surface, followed by chamfering and lapping.

Next, polishing was performed with a double side polishing machine for mirror finishing of both the surfaces. The processing conditions were a pressure of 100 g/cm² and a rotation speed of the lower surface plate of 20 rpm, and colloidal silica was used as an abrasive. Through the polishing, a 6-inch φ LN substrate with a thickness of 0.5 mm with a major surface being the Y surface was produced.

Other properties of the light guide member were as shown in Table 1.

Next, a multilayered antireflection film was formed on both the surfaces of the LN substrate. Then, the LN substrate was machined into 60 × 50 mm to produce a light guide member.

Smart glasses were produced using the light guide member, and an image projected on the smart glasses was visually observed. Then, the color reproducibility was inferior and some colors observed were different from those of the original image on the display. In addition, it was found that the luminance was inferior supposedly due to a low transmittance.

### <Comparative Example 2>

An LN single crystal ingot with a 6-inch diameter, which was pulled up by a CZ method with a crystal growth direction being the X axis direction, was sliced in an X cutting surface, followed by chamfering and lapping.

Next, polishing was performed with a double side polishing machine for mirror finishing of both the surfaces. The processing conditions were a pressure of 100 g/cm² and a rotation speed of the lower surface plate of 20 rpm, and colloidal silica was used as an abrasive. Through the polishing, a 6-inch φ LN substrate with a thickness of 0.2 mm with a major surface being the X surface was tried to be produced. However, fracture occurred in machining supposedly due to a small thickness, and thus, production of a substrate was failed.

### <Comparative Example 3>

An LN single crystal ingot with a 6-inch diameter, which was pulled up by a CZ method with a crystal growth direction being the X axis direction, was sliced in an X cutting surface, followed by chamfering and lapping.

Next, polishing was performed with a double side polishing machine for mirror finishing of both the surfaces. The processing conditions were a pressure of 150 g/cm² and a rotation speed of the lower surface plate of 5 rpm, and colloidal silica was used as an abrasive. Through the polishing, a 6-inch φ LN substrate with a thickness of 0.6 mm with a major surface being the X surface was produced.

Other properties of the light guide member were as shown in Table 1.

Next, a multilayered antireflection film was formed on both the surfaces of the LN substrate. Then, the LN substrate was machined into 60 × 50 mm to produce a light guide member.

Smart glasses were produced using the light guide member, and an image projected on the smart glasses was visually observed. Then, blurriness or bleeding was found supposedly due to a deteriorated TTV and parallelism.

### <Comparative Example 4>

An LN single crystal ingot with a 6-inch diameter, which was pulled up by a CZ method with a crystal growth direction being the X axis direction, was sliced in an X cutting surface, followed by chamfering and lapping.

Next, polishing was performed with a double side polishing machine for mirror finishing of both the surfaces. The processing conditions were a pressure of 100 g/cm² and a rotation speed of the lower surface plate of 20 rpm, and cerium oxide was used as an abrasive. Through the polishing, a 6-inch φ LN substrate with a thickness of 0.6 mm with a major surface being the X surface was produced.

Other properties of the light guide member were as shown in Table 1.

Next, a multilayered antireflection film was formed on both the surfaces of the LN substrate. Then, the LN substrate was machined into 60 × 50 mm to produce a light guide member.

Smart glasses were produced using the light guide member, and an image projected on the smart glasses was visually observed. Then, it was found that the luminance was inferior supposedly due to a deteriorated surface roughness.

The following table shows details of Examples 1 to 5 and Comparative Examples 1 to 4.

**[Table 1]**

| | Material | Crystal orientation of first and second surfaces | Internal transmittance | TTV | Parallelism | Surface roughness Sq | | Thickness |
|---|---|---|---|---|---|---|---|---|
| | | | | | | First surface | Second surface | |
| | | | % | um | arcsec | nm | | mm |
| Example 1 | LN | X | 91.1 | 1.3 | 1.8 | 0.5 | 0.5 | 0.6 |
| Example 2 | LN | X | 93.5 | 1.8 | 2.4 | 0.7 | 0.6 | 0.6 |
| Example 3 | LN | X | 91.9 | 0.9 | 1.1 | 0.8 | 0.9 | 0.3 |
| Example 4 | LN | X | 92.1 | 0.8 | 1.1 | 0.7 | 0.6 | 1.0 |
| Example 5 | LN | Z | 96.0 | 1.3 | 1.6 | 0.7 | 0.4 | 0.6 |
| | | | | | | | | |
| Comparative Example 1 | LN | Y | 80.8 | 1.2 | 1.4 | 0.6 | 0.7 | 0.6 |
| Comparative Example 2 | LN | X | - | - | - | - | - | 0.2 |
| Comparative Example 3 | LN | X | 93.0 | 2.5 | 3.0 | 1.0 | 0.8 | 0.6 |
| Comparative Example 4 | LN | X | 92.5 | 1.8 | 2.1 | 2.3 | 1.9 | 0.6 |

The embodiments described above are examples, and any embodiments that have substantially the same configuration and the same effects as those of the technical idea described in the claims of the present invention are within the technical scope of the present invention.

### Reference Signs List

1: Crystal structure of lithium niobate
2: Light guide member
3: Display
4: Input grating
5: Output grating

## Claims

1. A light guide member for use in a waveguide structure of an image display device, which waveguide structure guides image light entering from a display to emit the image light toward an eye of a user,
the light guide member being formed of a single crystal of lithium niobate.

2. The light guide member according to claim 1, wherein the light guide member has a first surface and a second surface facing each other,
the first surface and the second surface each having a plane orientation in an X axis direction or a Z axis direction of crystallographic axes.

3. The light guide member according to claim 2, wherein a difference between a maximum value and a minimum value of a distance from the first surface to the second surface is 2 µm or less.

4. The light guide member according to claim 2 or 3, wherein a parallelism between the first surface and the second surface is 2.5 arcsec or less.

5. The light guide member according to claim 2 or 3, wherein the first surface and the second surface of the light guide member each have a surface roughness Sq of 1 nm or less.

6. The light guide member according to claim 1 or 2, wherein the light guide member has an internal transmittance of light at a wavelength of 400 to 800 nm of 90% or more as calculated based on a thickness of 10 mm.

7. The light guide member according to claim 1 or 2, wherein the light guide member has a plate thickness of 0.3 mm or more and 1.0 mm or less.
